# EUROPEAN PATENT SPECIFICATION

(11) **EP 3 242 330 B1**
(45) Date of publication and mention of the grant of the patent: **17.06.2020**
(21) Application number: 17168849.2
(22) Date of filing: 28.04.2017
(51) Int. Cl.: H01L 29/868, H01L 29/36, H01L 29/08, H01L 21/329, H01L 29/32, H01L 21/322, H01L 29/861, H01L 29/167

(54) **DIODE AND POWER CONVERTOR USING THE SAME**
DIODE UND STROMWANDLER DAMIT
DIODE ET CONVERTISSEUR DE PUISSANCE L'UTILISANT

(30) Priority: 02.05.2016 JP 2016092229
(43) Date of publication of application: 08.11.2017
(73) Proprietor: Hitachi Power Semiconductor Device, Ltd., Hitachi-shi, Ibaraki 319-1221 (JP)
(72) Inventor: ARAI, Taiga, Tokyo, 100-8280 (JP); WAKAGI, Masatoshi, Tokyo, 100-8280 (JP); ISHIMARU, Tetsuya, Tokyo, 100-8280 (JP); MORI, Mutsuhiro, Tokyo, 100-8280 (JP)
(74) Representative: MERH-IP Matias Erny Reichl Hoffmann Patentanwälte PartG mbB

(56) References cited:
- JP-A- H06 216 400
- JP-A- 2002 016 265
- JP-A- 2005 079 232
- US-A1- 2005 230 702
- US-A1- 2016 056 306
- RAHIMO M T ET AL: "A NOVEL CONCEPT FOR FAST RECOVERY DIODES HAVING JUNCTION CHARGE EXTRACTION (JCE) REGIONS", PROCEEDINGS OF THE 10TH INTERNATIONAL SYMPOSIUM ON POWER SEMICONDUCTOR DEVICES & IC'S. ISPSD '98. KYOTO, JUNE 3 - 6, 1998; [INTERNATIONAL SYMPOSIUM ON POWER SEMICONDUCTOR DEVICES & IC'S], NEW YORK, NY : IEEE, US, 3 June 1998 (1998-06-03), pages 309-312, XP000801086, DOI: 10.1109/ISPSD.1998.702695 ISBN: 978-0-7803-4752-6

## Description

### BACKGROUND OF THE INVENTION

### 1. Field of the Invention

The present invention relates to a diode and a power convertor using the same.

### 2. Background Art

A power convertor uses diodes as freewheel diodes connected in anti-parallel to insulated gate bipolar transistors (IGBTs) or metal oxide semiconductor field effect transistors (MOS transistors). Such diodes have been required to reduce losses from the viewpoint of energy saving and to reduce noise for reliability and controllability.

As typical losses of the diode, there are a forward voltage drop (VF: Forward Voltage) equivalent to a turn-on loss, and a reverse recovery switching loss (Err: Reverse Recovery Loss). Main contributors to reductions in the losses of power conversion systems are a reduction in VF in the case of low drive frequency devices such as convertors, and a reduction in Err in the case of high drive frequency devices such as inverters. Hence, in recent years, there has been a demand for further reductions in VF and Err. In this connection, a high resistance drift layer that holds a high voltage in an OFF state makes it possible to reduce VF when the drift layer is formed to allow a larger amount of carries to be injected and accumulated therein and to have a smaller thickness. Meanwhile, the high resistance drift layer also makes it possible to reduce Err when the drift layer is formed to allow a smaller amount of carries to be accumulated therein and to cause the carriers to decay within a short period of time in a reverse recovery.

On the other hand, as for a noise reduction, the following phenomenon occurs. Specifically, at reverse recovery switching, unless a period of a natural decay of accumulated carriers, what is termed as a tail current, is not sufficiently obtained due to a sharp drop of electric current, such a sudden decay of the current generates a surge voltage (L·dI/dt) proportional to the parasitic inductance in the main circuit, and causes oscillation at frequencies of several MHz or more. Accordingly, there arise concerns about adverse effects such as breakdown of motor insulation, element breakdown caused by overvoltage, and element malfunction.

The following conventional techniques have been disclosed for the purpose of solving the problems of a loss reduction and a noise reduction.

Patent Literature 1 discloses a technique related to a diode, and states "[Problem] Provide is a low-loss diode excellent in dielectric strength characteristics and oscillation characteristics. [Solving Means] In a Si wafer having a wafer thickness of 340 to 380 µm, an n buffer (nB) layer is formed by diffusing an n type dopant in a dose amount of 5×10¹¹ to 1×10¹³ cm⁻² into a depth in a range of 50 to 130 µm in the wafer. [Selected Drawing] FIG. 1 (see [Abstract])." Here, [Selected Drawing] FIG. 1 in Abstract of Patent Literature 1 is attached as FIG. 13 in the drawings of the present application.

In addition, Patent Literature 2 discloses a technique related to a diode, and states "[Problem] Provided is a high voltage diode capable of preventing generation of electromagnetic noise and breakdown of the diode by accumulating holes in an n⁺ type stopper layer (cathode layer), thereby relaxing a current change rate and preventing a surge voltage. [Solving Means] A diode includes a p+ type anode layer 12 formed on one surface of an n⁻ type semiconductor substrate 11 and an n⁺ type stopper layer (cathode layer) 13 formed on the other surface of the n⁻ type semiconductor substrate 11. The total amount of impurities per unit area of the n⁺ type stopper layer 13 is 2.5×10¹⁵ cm⁻² or less, and the depth of the n⁺ type stopper layer 13 is 40 µm or more. (see [Abstract])." Here, the drawing in Abstract of Patent Literature 1 is attached as FIG. 14 in the drawings of the present application.

### [Prior Art Documents]

### [Patent Literatures]

Patent Literature 1: JP 2014-146721 A
Patent Literature 2: JP 2002-016265 A

US 2005/230702 A1 realizes a high-voltage diode with a turn-off behavior that is optimized in a targeted manner. By means of an irradiation either only from the side of the n+-conducting cathode emitter or from both sides, i.e. from the side of the n+-conducting cathode emitter and from the side of the p+-conducting anode emitter, it is possible to obtain a soft recovery behavior of the component by means of a targeted setting of the lifetime of the charge carriers without in this case increasing the on-state losses.

JP 2005079232 A relates to providing a high breakdown voltage switching diode having a breakdown voltage of 200 V or above which has a low forward voltage and little backward current and has excellent switching characteristics.

JP H 06216400 A relates to improving withstand voltage and reducing a switching loss by forming a cathode side of a diode of a two-layer structure of low concentration n<+> type and high concentration n<++> type, implanting proton, etc., at the cathode side, and providing a region having a partly short lifetime.

US 2016/056306 A1 relates to a configuration, wherein a p-type anode layer is provided on an upper surface of an n-type drift layer. An n-type cathode layer is provided on a lower surface of the n--type drift layer. An n-type buffer layer is provided between the n--type drift layer and the n-type cathode layer. A peak impurity concentration in the n-type buffer layer is higher than that in the n--type drift layer and lower than that in the n-type cathode layer.

JP 2016-15392 A discloses a diode comprising a buffer layer between the cathode layer and the drift layer and including a lifetime control layer consisting of a plurality of segments arranged on a plane parallel to the main surfaces of the diode. The lifetime control layer is formed in the portion of the buffer layer having a lower doping concentration.

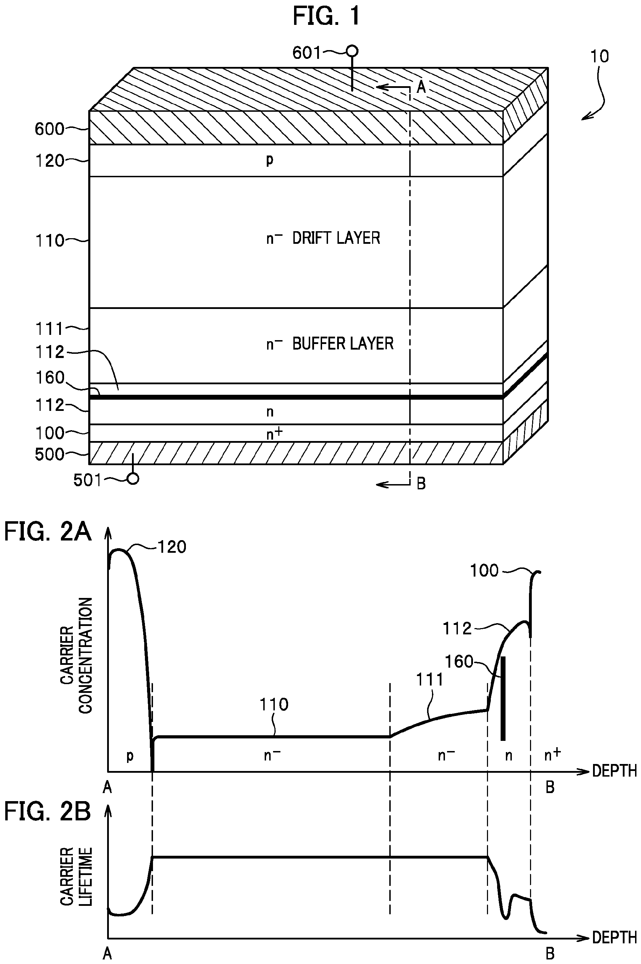

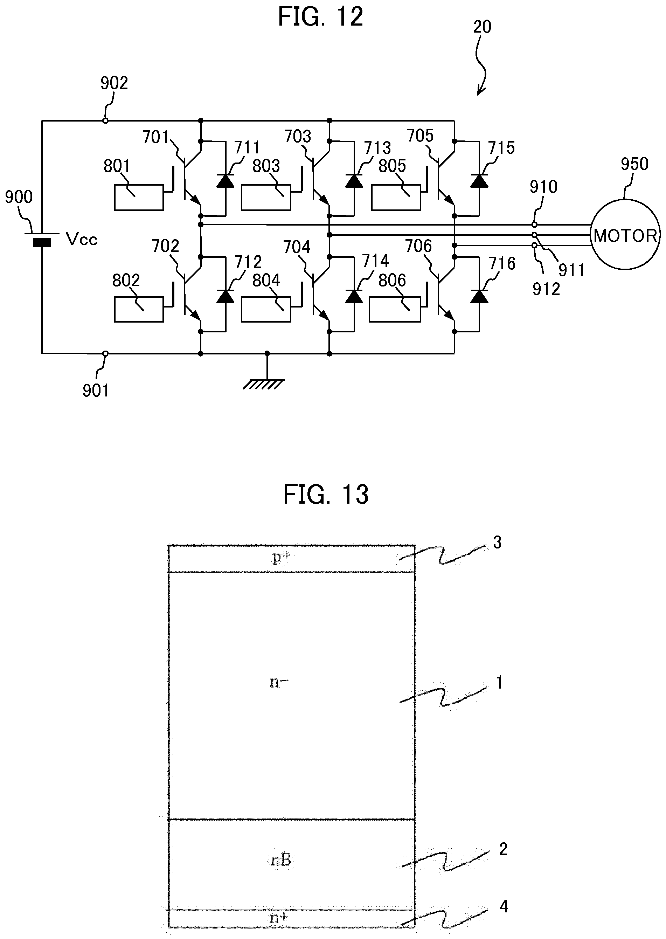

However, if the structure illustrated in FIG. 1 (attached as FIG. 13 in the present application) in [Selected Drawing] of [Abstract] in Patent Literature 1 is formed by P implantation at a dose of 1×10¹⁵ cm⁻² and activation by thermal treatment at 1000°C specifically described in [0026] and [0033], the cathode structure thus obtained is a high carrier injection structure, and a tail current in reverse recovery switching is large and long. Moreover, there is also room for improvement in a loss (Err) in reverse recovery switching.

Meanwhile, if the n⁺ type stopper layer in the structure illustrated in the drawings (attached as FIGs. 14A to 14C in the present application) of [Abstract] in Patent Literature 2 has 2.5×10¹⁵ cm⁻² or less of impurities and a depth of 40 µm as described in [0015], the n⁺ type stopper layer has an average volume concentration of 6.1×10¹⁷ cm⁻³, and a carrier lifetime equal to or less than 1/10 of that of the n⁻ type semiconductor substrate region. In other words, unless the carrier lifetime distribution dependent on the volume concentration is considered, there is a problem in that a surge due to a carrier decay may occur irrespective of the location of the low carrier lifetime control layer introduced.

Moreover, Patent Literature 2 does not provide quantitative description of a peak and a depth distribution of the volume concentration in the n⁺ type stopper layer, nor describe their influences on the effect. This is also a problem because it is essential to specify the peak of the volume concentration in the n⁺ type stopper layer in order to ensure the surge suppression effect in Patent Literature 2.

In addition, Patent Literature 1 and Patent Literature 2 do not describe leakage current characteristics in a state of maintaining dielectric strength. If a depletion layer reaches the low lifetime control layer at a static dielectric strength, which is set to be higher than a dynamic applied voltage, the leakage current is expected to increase. This leakage current is problematic because it may tend to cause element breakdown or deterioration due to a temperature rise.

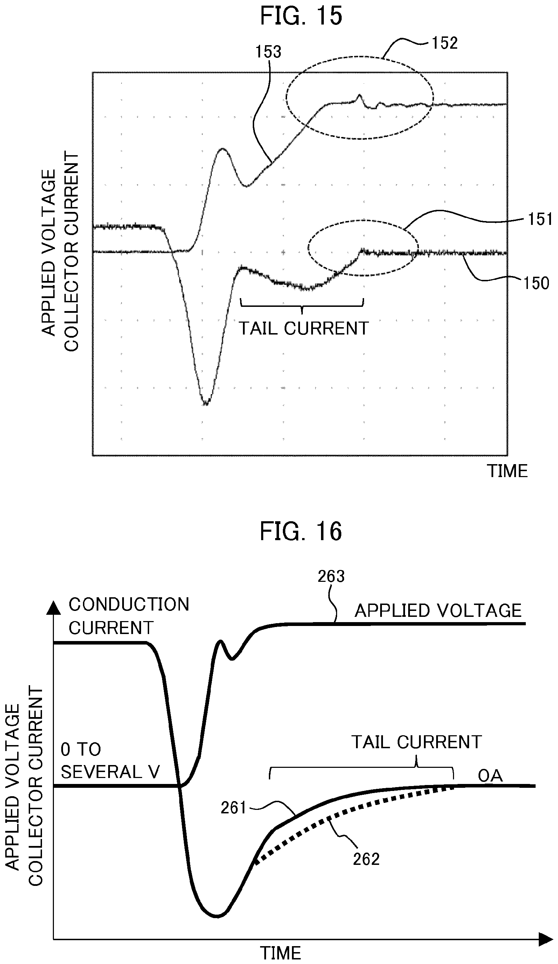

Here, FIG. 15 is a diagram presenting an example of waveforms actually measured in an experiment of a diode prototype fabricated by the present inventors based on the structure of Patent Literature 1 with a low carrier lifetime control layer suggested in Patent Literature 2 introduced thereto, the experiment conducted under reverse recovery switching conditions of high bias and small current.

In the actually-measured waveforms in FIG. 15, although a large tail current is obtained, the tail current (a characteristic line 151) steeply decays (characteristic lines 151 and 150) and a surge voltage and an oscillation phenomenon (ringing: a characteristic line 152) are observed in the voltage waveform (characteristic lines 152 and 153).

In summary, even if the techniques disclosed in Patent Literatures 1 and 2 are combined, it is difficult to solve the aforementioned problems concurrently.

The present invention has been made in view of the foregoing problems, and is intended to provide a diode and a power convertor using the same, the diode achieving: an improvement in the tradeoff between a conduction loss and a switching loss of the diode; suppressions of a surge voltage and a high frequency oscillation during reverse recovery switching; and a reduction in a leakage current, which may cause element breakdown or deterioration, in a state of maintaining dielectric strength.

### SUMMARY OF THE INVENTION

In order to solve the aforementioned problem, it is provided a diode having the features defined in claim 1. Further preferred arrangements are defined in dependent claims 2 and 3. Moreover, it is provided a power converter comprising the inventive diode according to claim 4. Other constituent elements are described in DETAILED DESCRIPTION OF THE ARRANGEMENTS.

According to the present invention, it is possible to provide a diode and a power convertor using the same, the diode achieving: an improvement in the tradeoff between a conduction loss and a switching loss of the diode; preventions of a surge voltage and a high frequency oscillation during reverse recovery switching; and a reduction in a leakage current, which may cause element breakdown or deterioration, in a state of maintaining dielectric strength.

### BRIEF DESCRIPTION OF THE DRAWINGS

FIG. 1 is a diagram showing an example of an upper surface and a cross section of a diode according to a first arrangement useful to understand the present invention.
FIGs. 2A and 2B are diagrams showing an example of depth-direction cross-sectional profiles on a cross section, taken along a line A-B in FIG. 1, of the diode according to the first arrangement.
FIG. 2A presents a carrier concentration in the depth direction, and FIG. 2B presents a carrier lifetime in the depth direction.

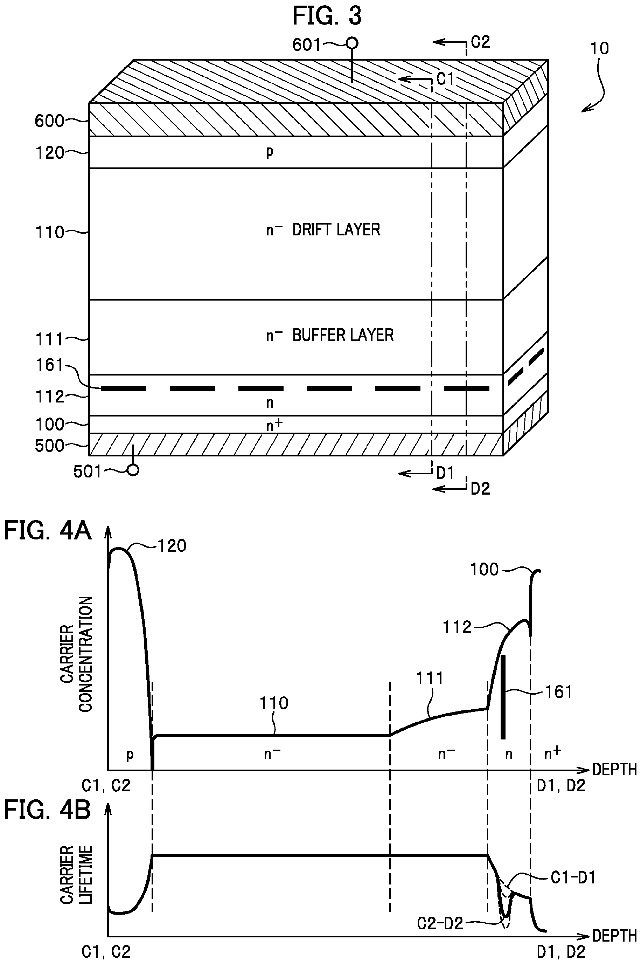

FIG. 3 is a diagram showing an example of an upper surface and a cross section of a diode according to a second arrangement. The second arrangement is an example of the present invention.
FIGs. 4A and 4B are diagrams showing an example of depth-direction cross-sectional profiles on cross sections, taken along lines C1 - D1 and C2-D2 in FIG. 3, of the diode according to the second arrangement.
FIG. 4A presents a carrier concentration in the depth direction, and FIG. 4B presents a carrier lifetime in the depth direction.

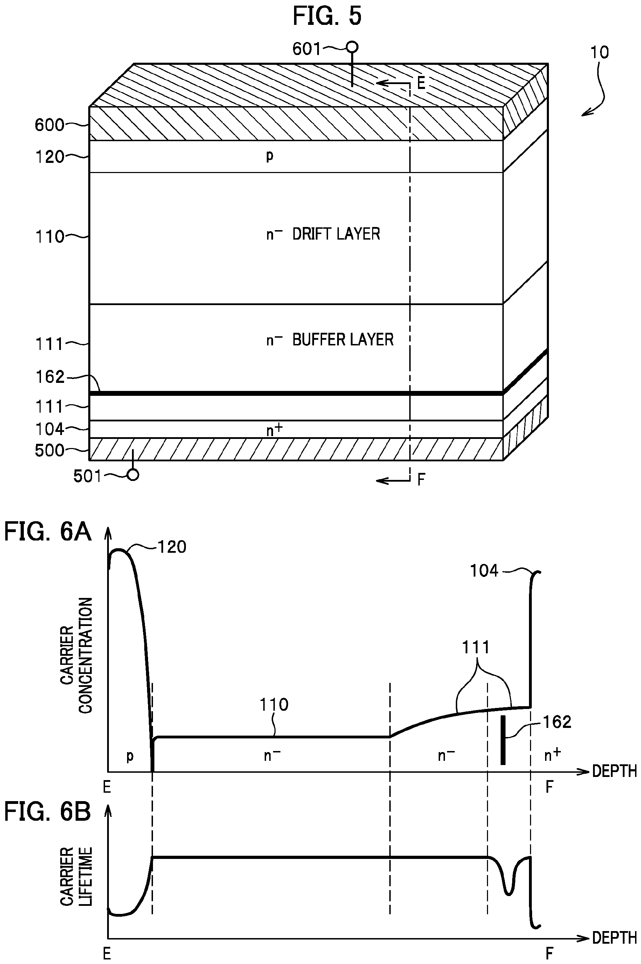

FIG. 5 is a diagram showing an example of an upper surface and a cross section of a diode according to a third arrangement useful to understand the present invention.
FIGs. 6A and 6B are diagrams showing an example of depth-direction cross-sectional profiles on a cross section, taken along a line E-F in FIG. 5, of the diode according to the third arrangement. FIG. 6A presents a carrier concentration in the depth direction, and FIG. 6B presents a carrier lifetime in the depth direction.

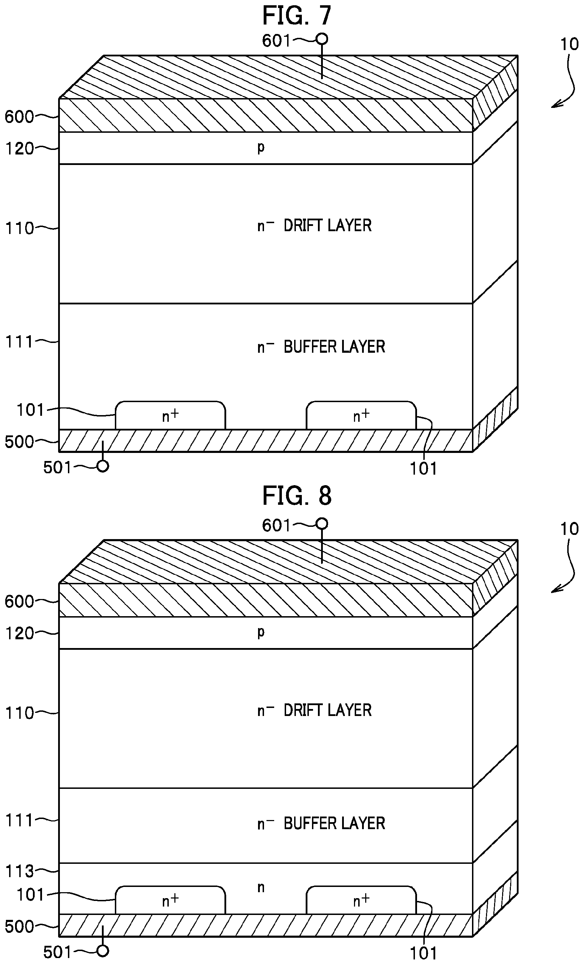

FIG. 7 is a diagram showing an example of an upper surface and a cross section of a diode according to a fourth arrangement useful to understand the present invention.
FIG. 8 is a diagram showing an example of an upper surface and a cross section of a diode according to a fifth arrangement useful to understand the present invention.

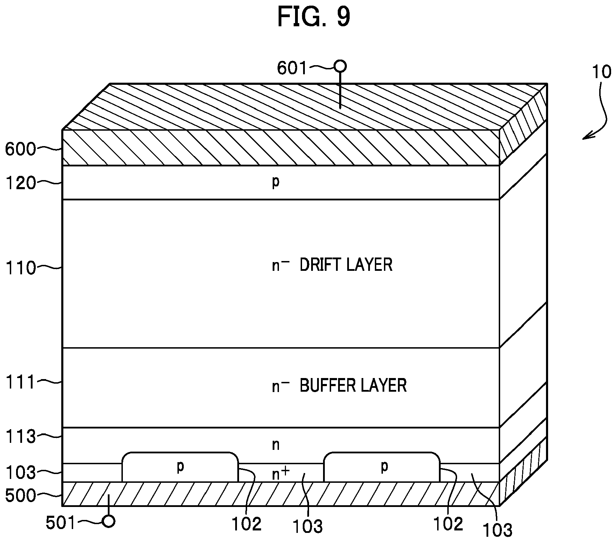

FIG. 9 is a diagram showing an example of an upper surface and a cross section of a diode according to a sixth arrangement useful to understand the present invention.

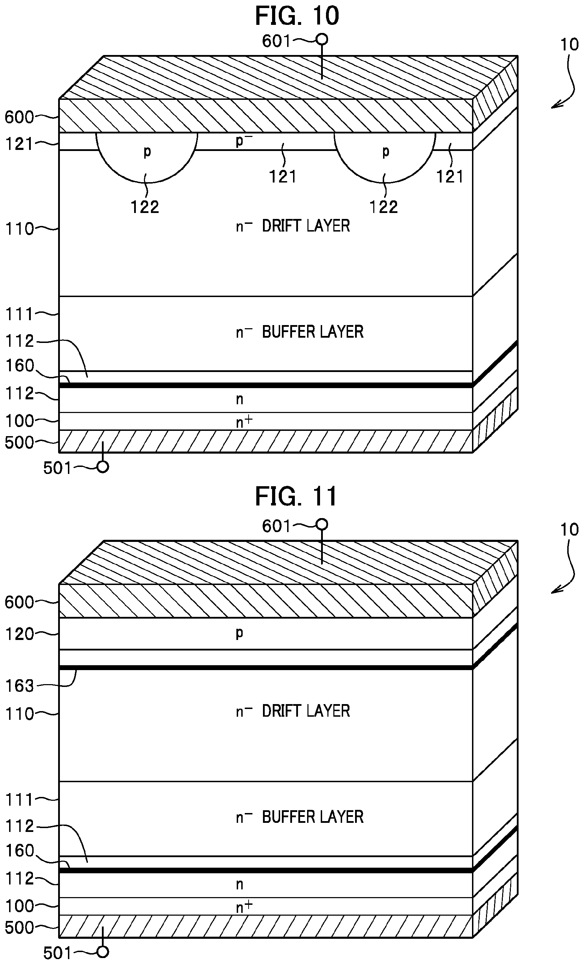

FIG. 10 is a diagram showing an example of an upper surface and a cross section of a diode according to a seventh arrangement useful to understand the present invention.
FIG. 11 is a diagram showing an example of an upper surface and a cross section of a diode according to an eighth arrangement useful to understand the present invention.
FIG. 12 is a diagram showing a configuration example of a power convertor according to a ninth arrangement of the present invention. The power converter in Fig. 12 is an example of the present invention.
FIG. 13 is a diagram presented in [Selected Drawing] in [Abstract] of Patent Literature 1.

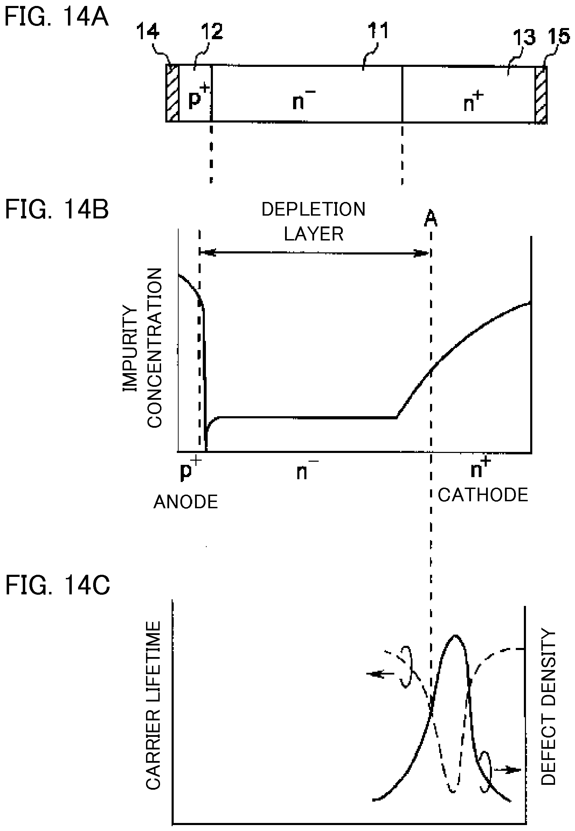

FIGs. 14A to 14C are diagrams presented in [Abstract] of Patent Literature 2.
FIG. 15 is a diagram presenting an example of waveforms actually measured in an experiment of a diode prototype fabricated by the present inventors based on the structure of Patent Literature 1 with a low carrier lifetime control layer suggested in Patent Literature 2 introduced thereto, the experiment conducted under reverse recovery switching conditions of high bias and small current.
FIG. 16 is a diagram showing an example of voltage and current waveforms over time during reverse recovery switching of the diode according to the first arrangement.

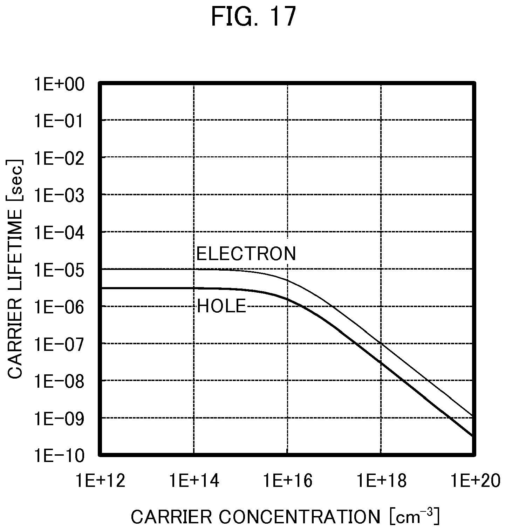

FIG. 17 is a diagram showing an example of a carrier volume concentration dependency of a carrier lifetime.

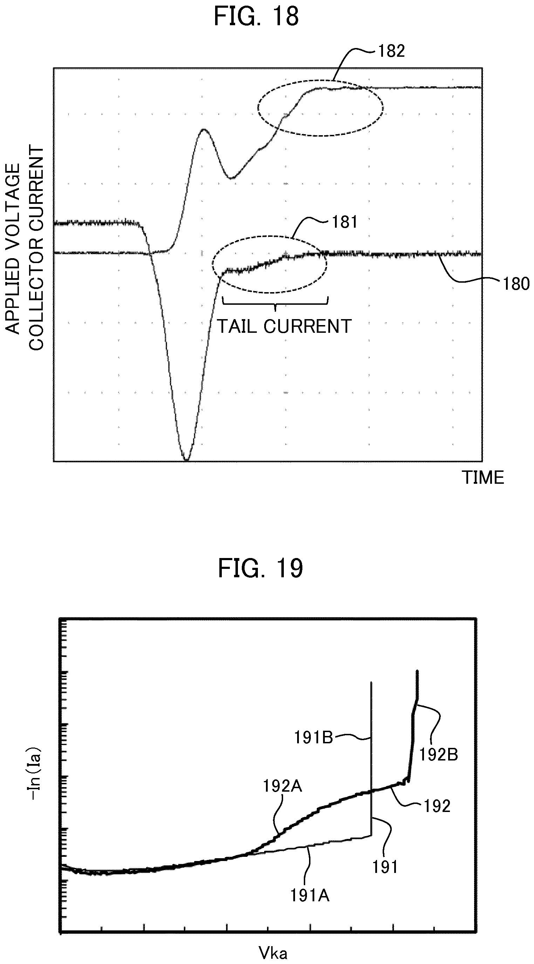

FIG. 18 is a diagram showing an example of a tail current characteristic in the case of using the diode according to the first arrangement.
FIG. 19 is a diagram showing an example of the characteristic of a leakage current in reverse voltage blocking in the case of using the diode according to the first arrangement.

### DETAILED DESCRIPTION OF THE ARRANGEMENTS

It should be noted that, in the drawings for explaining the arrangements, elements having the same function are indicated by the same sign, and the redundant explanation thereof is omitted if not needed. In addition, in the following explanation of the arrangements, the explanation of the same or similar elements is also omitted except that the explanation is particularly needed. In the following there are described some arrangements, in particular, the second arrangement shown in Figs. 3, 4A and 4B is an example of the present invention. The further arrangements of diodes are helpful for understanding the present invention.

### <<First Arrangement>>

A diode 10 of a first arrangement is described with reference to the drawings.

### <<Outline of Structure of Diode 10>>

FIG. 1 is a diagram showing an example of an upper surface and a cross section of the diode 10 according to the first arrangement.

In FIG. 1, the diode 10 is formed between an anode electrode layer 600 to which an anode electrode 601 is connected, and a cathode electrode layer 500 to which a cathode electrode 501 is connected.

Here, the anode electrode layer 600 and the cathode electrode layer 500 are layers mainly containing metal.

The anode electrode layer 600 is in contact with an upper surface (an upper surface in the drawing) of a p type semiconductor layer 120 (a second semiconductor layer of a second conductivity type).

A lower surface of the p type semiconductor layer 120 is in contact with an upper surface of an n⁻ drift layer 110 (a first semiconductor layer of a first conductivity type).

A lower surface of the n⁻ drift layer 110 is in contact with an upper surface of a deep n⁻ buffer layer 111 (a buffer layer of the first conductivity type).

A lower surface of the deep n⁻ buffer layer 111 is in contact with an upper surface of a shallow n buffer layer 112 (a third semiconductor layer of the first conductivity type).

A low carrier lifetime control layer (a low carrier lifetime layer or a low carrier lifetime region) 160 is formed in the shallow n buffer layer 112.

A lower surface of the shallow n buffer layer 112 is in contact with an upper surface of a high-concentration n⁺ layer 100 (a fourth semiconductor layer of the first conductivity type).

A lower surface of the high-concentration n⁺ layer (a high-concentration n⁺ region) 100 is in contact with the aforementioned cathode electrode layer 500.

### <<Outline of Concentration Distribution of Carriers in Diode 10>>

Next, an outline of a concentration distribution of carriers (impurities) in the diode 10 in the first arrangement is explained with reference to FIGs. 2A and 2B.

FIGs. 2A and 2B are diagrams showing an example of depth-direction cross-sectional profiles on a cross section, taken along a line A-B in FIG. 1, of the diode 10 according to the first arrangement of the present invention. FIG. 2A presents a carrier concentration (distribution) in the depth direction, and FIG. 2B presents a carrier lifetime (distribution) in the depth direction.

Note that a carrier lifetime is an average time it takes for excessive minority carriers increased from the thermal equilibrium state to recombine (a time it takes to reduce to e⁻¹ times) .

In FIG. 2A, a carrier concentration (vertical axis) in the depth direction (horizontal axis) corresponds to, in order from the anode side, the p type semiconductor layer 120, the n⁻ drift layer 110, the deep n⁻ buffer layer 111, the shallow n buffer layer 112 containing the low carrier lifetime control layer 160, and the high-concentration n⁺ layer 100 in FIG. 1.

Here, the p type semiconductor layer 120 has a different carrier polarity (p) from the carrier polarity (n) of the n⁻ drift layer 110, the deep n⁻ buffer layer 111, the shallow n buffer layer 112, and the high-concentration n⁺ layer 100, but is presented just from the viewpoint of the carrier concentration.

In addition, the low carrier lifetime control layer 160 is represented by a line, but the line just indicates the location of the low carrier lifetime control layer 160 in the depth direction, and does not mean that the low carrier lifetime control layer 160 has a carrier concentration distributed widely corresponding to the length of the line.

Corresponding to the distribution of the carrier concentration in FIG. 2A, a carrier lifetime (vertical axis) in the depth direction (horizontal axis) in FIG. 2B has a rough tendency that the higher the carrier concentration, the lower the carrier lifetime. Then, the carrier lifetime becomes low at a point (depth) corresponding to the low carrier lifetime control layer 160 in FIG. 2A.

The concentration and the thickness of each constituent region in the structure of the diode 10 according to the first arrangement are determined under the constraints imposed by the rated voltage of the diode.

In the case where the diode 10 is configured as a high voltage silicon diode in the kV order, the p type semiconductor layer 120 on the anode side of the diode 10 has a depth of about 5 to 10 µm and of 20 µm or less.

Then, the total thickness of the n⁻ drift layer 110 and the deep n⁻ buffer layer 111 is about 50 to 1000 µm, and the carrier concentration in the n⁻ drift layer 110 is about 1×10¹³ to 1×10¹⁵ cm⁻³. However, the carrier concentration in the n⁻ drift layer 110 does not reach 1 × 10¹⁵ cm⁻³.

Moreover, the deep n- buffer layer 111 has a thickness of 30 µm or more, and has a carrier concentration (volume concentration) higher than the carrier concentration in the n⁻ drift layer 110 but less than 1×10¹⁵ cm⁻³.

Here, the total carrier (the area concentration as viewed from the upper surface of FIG. 1) in the deep n⁻ buffer layer 111 is 1×10¹¹ to 1×10¹³ cm⁻².

Note that "cm⁻²" means "the number of carriers/cm²" and "cm⁻³" means "the number of carriers/cm³".

### <<Low Carrier Lifetime Control Layer>>

In the structure of the diode 10 according to the first arrangement, the low carrier lifetime control layer 160 is formed in the deep n⁻ buffer layer 111 in order to suppress carrier injection from the cathode.

To form the shallow n buffer layer 112, n type impurities are implanted into a region of 1.5 to 10 µm from the cathode electrode layer such that the area concentration of the impurities viewed from the upper surface in FIG. 1 becomes 1×10¹¹ to 1×10¹³ cm⁻². Then, in the process of laser annealing of the shallow n buffer layer 112, all the impurities in the above region are not activated, but a defect layer is left in its internal region, so that a structure can be formed which includes the low carrier lifetime control layer 160 and thus can reduce carrier injection to a low level.

In FIGs. 2A and 2B, the distribution of the low carrier lifetime control layer 160 is independent of the distribution of the carrier concentration of the shallow n buffer layer 112.

Moreover, a portion having a low carrier lifetime has a high resistance value when viewed as a resistor. Accordingly, the resistance distribution (specific resistance distribution) of the low carrier lifetime control layer 160 is independent of the carrier distribution of the shallow n buffer layer 112.

In other words, the low carrier lifetime control layer 160 has a specific resistance distribution exhibiting a high resistance peak independent of the carrier distribution (impurity concentration distribution) in the shallow n buffer layer 112.

Moreover, in this case, the optimum impurity concentration in the shallow n buffer layer 112 is 5×10¹¹ to 5×10¹² cm⁻², and the shallow n buffer layer 112 desirably has a depth of 3 to 5 µm.

In addition, for an ohmic contact with the cathode electrode 501 and the cathode electrode layer 500, the high-concentration n⁺ layer 100 is formed in a region of 1.5 µm or less from the contact surface with the cathode electrode layer 500 such that the high-concentration n⁺ layer 10 has a total carrier (area concentration) of about 1×10¹⁵ cm⁻² and a volume concentration of 1×10¹⁸ to 10²¹ cm⁻³.

### <<Effect by Carrier Suppression>>

The diode 10 according to the first arrangement includes the deep n⁻ buffer layer 111 between the anode electrode layer 600 and the cathode electrode layer 500, more specifically, in the region extending to a location at a distance of 30 µm or more from the cathode electrode layer 500. Note that the carrier concentration in the deep n⁻ buffer layer 111 is less than 1×10¹⁵ cm⁻³.

Moreover, the diode 10 includes the n⁻ drift layer 110 in the region between the anode electrode layer 600 and the deep n⁻ buffer layer 111, the n⁻ drift layer 110 having high resistance with a lower carrier concentration than that of the deep n⁻ buffer layer 111.

Further, the diode 10 includes the p type semiconductor layer 120 in the region between the anode electrode layer 600 and the n⁻ drift layer 110.

Having the constituent elements described above, the diode 10 has the structure which includes the deep n⁻ buffer layer 111 with the carrier concentration of less than 1×10¹⁵ cm⁻³, and can suppress carrier injection from the cathode electrode 501 and the cathode electrode layer 500 via the shallow n buffer layer 112 and the deep n⁻ buffer layer 111 into the n⁻ drift layer 110 having the high resistance.

In the diode with such a structure, the amount of carriers involved in the process of discharging carriers from the inside to turn into the off state in reverse recovery switching is so small that a high switching speed can be achieved and thus a loss in the reverse recovery switching can be reduced.

### <Voltage and Current Characteristics during Reverse Recovery Switching>

Next, description is provided for voltage and current characteristics during reverse recovery switching of the diode 10 according to the first arrangement.

FIG. 16 is a diagram showing an example of voltage and current waveforms over time during reverse recovery switching of the diode 10 according to the first arrangement.

In FIG. 16, the vertical axis indicates a collector current (a cathode current) and an applied voltage (an applied power supply voltage) of the diode 10, and the horizontal axis indicates time (passage of time).

Then, a characteristic line 261 demonstrates a conduction current characteristic of the diode 10 according to the first arrangement, whereas a characteristic line 262 demonstrates a conduction current characteristic of one example of the conventional technique. Meanwhile, a characteristic line 263 demonstrates an applied voltage (an applied power supply voltage) during reverse recovery switching.

In FIG. 16, the low injection structure explained by using the diode 10 according to the first arrangement has a smaller amount of carriers on the cathode side, and accordingly has a smaller tail current portion as in the current waveform of the characteristic line 261.

In this tail current region, the voltage already rises to a high level around the power supply voltage, and an incurred loss, which is a product of the voltage and the current, may possible become very large. However, making the tail current portion smaller (making the current close to 0 A) as in the aforementioned current waveform of the characteristic line 261 significantly contributes to the effect of reducing the reverse recovery switching loss. Here, in FIG. 16, "0A" means zero amperes.

### <Tail Current and Oscillation Phenomenon>

In the structure of the diode 10 according to the first arrangement, the deep n⁻ buffer layer 111 suppresses an oscillation phenomenon by lowering the decay speed of the injected carriers in the recovery and making the tail current phenomenon moderate, and thereby makes it possible to manufacture a diode formed with a thinner wafer, and achieving a loss reduction while ensuring a sufficient dielectric strength.

### <Carrier Volume Concentration Dependency of Carrier Lifetime>

Next, a carrier volume concentration dependency of a carrier lifetime is explained.

FIG. 17 is a diagram showing an example of a carrier volume concentration dependency of a carrier lifetime.

In FIG. 17, the vertical axis indicates a carrier lifetime [sec], and the horizontal axis indicates a carrier concentration. The characteristics of electrons and holes are demonstrated.

As presented in FIG. 17, the carrier lifetime in a range of a carrier concentration of 1×10¹⁵ cm⁻³ or more sharply becomes shorter as the carrier concentration becomes higher. However, the carrier lifetime in a range of a carrier concentration of less than 1×10¹⁵ cm⁻³ is kept long independently of the carrier concentration.

Accordingly, the deep n⁻ buffer layer 111 having a carrier distribution with a peak concentration of less than 1×10¹⁵ cm⁻³ as in the diode 10 according to the first arrangement is a high lifetime region independent of the carrier distribution.

With this characteristic maintained, the depletion speed during reverse recovery switching can be lowered depending on the concentration in the buffer layer. Additionally, the generation of ringing noise is suppressed by preventing carrier decay and obtaining a sufficient tail current region.

### <<Formation of Deep n⁻ Buffer Layer 111>>

As for the formation of the deep n⁻ buffer layer 111 in FIG. 1, the inventors made calculation and fabrication of an experiment prototype, and thus verified that the deep n⁻ buffer layer 111 needs to have a thickness 30 µm of more with the view of sufficiently preventing the depletion layer from reaching the low lifetime layer located near the cathode electrode.

For the same purpose, the deep n⁻ buffer layer 111 needs to have a total carrier (an area concentration viewed from the upper surface in FIG. 1) of 1×10¹¹ to 1×10¹³ cm⁻². In other words, the thickness can be said to be a thickness prescribed by a profile in which the concentration peak of the carrier concentration (volume concentration) fulfills 1×10¹⁵ cm⁻³.

Moreover, providing the n type drift layer with a low carrier concentration between the deep n⁻ buffer layer 111 and the p type semiconductor layer 120 on the anode side makes it possible to reduce the electric field in this portion in a reverse bias operation, thereby ensuring the dielectric strength, and also keeping favorable cosmic ray ruggedness characteristics.

In the case of a silicon semiconductor layer, the deep n⁻ buffer layer 111 is formed by mainly diffusing P, As, Sb, or the like. These elements can achieve a high activation rate of n type carriers and accordingly enable an n layer to be formed with a desired concentration.

### <<High-Concentration n⁺ Layer 100>>

Moreover, for the ohmic contact with the cathode electrode (cathode electrode layer 500), the high-concentration n⁺ layer 100 with a concentration of 1×10¹⁹ cm⁻³ or more is preferably formed on the whole or part of the contact surface with the cathode electrode. Further, the more desirable concentration is 1×10²⁰ cm⁻³ or more.

This high-concentration n⁺ layer 100 is equivalent to the low lifetime layer near the cathode electrode.

The high-concentration n⁺ layer 100 is just intended to establish the ohmic contact and therefore is desirably a thin layer with a thickness of less than 1 µm.

This is because the high-concentration n⁺ layer 100 contributes as the resistance component to an increase in the forward voltage drop VF, and increases the forward voltage drop VF according to its thickness. Further, when the high-concentration n⁺ layer 100 is formed not on the entire contact surface but is formed as partial contacts, carrier injection from the cathode can be also reduced.

### <Actual Measurement Example 1 of First Arrangement >

In the diode 10 according to the first arrangement, the inventors confirmed using the experiment prototype that the tail current itself is small owing to a reduction in the injection itself from the cathode, and the current stops softly without the depletion layer causing a sharp decay of the remaining carriers.

FIG. 18 presents an example of waveforms obtained in this actual measurement.

FIG. 18 is a diagram showing an example of a tail current characteristic in a collector current (cathode current) in the case of using the diode 10 according to the first arrangement.

In FIG. 18, the vertical axis indicates an applied voltage (a voltage between anode and cathode: a characteristic line 182) and a collector current (a cathode current: a characteristic line 181) of the diode 10 according to the first arrangement, and the horizontal axis indicates time (passage of time).

In FIG. 18, it can be observed that the tail current in the characteristic line 181 is small and softly decays (a characteristic line 180). Moreover, it can be also observed that an oscillation does not occur because there is no ringing phenomenon in the voltage between anode and cathode in the characteristic line 182.

As seen from a comparison between FIG. 18 (the characteristics of the first arrangement) and FIG. 15 (the characteristics in an experiment based on the assumption that the structures of Patent Literatures 1 and 2 are combined), the diode 10 according to the first arrangement is improved in the following two points: "the tail current is small and softly decays"; and " an oscillation does not occur because there is no ringing phenomenon."

### <Actual Measurement Example 2 of First Arrangement: Deep n⁻ Buffer Layer>

In addition, the present inventors actually measured the effect of reducing a leakage current in reverse voltage blocking, as an effect that the deep n⁻ buffer layer structure produced on a low injection structure from the cathode.

FIG. 19 is a diagram showing an example of the characteristic of a leakage current in reverse voltage blocking in the case of using the diode 10 according to the first arrangement. FIG. 19 also presents the characteristic example of the conventional technique together for comparison.

In FIG. 19, the horizontal axis indicates the voltage (Vka) between the anode and the cathode of the diode, and the vertical axis indicates the anode current (Ia) in natural logarithm. Further, a characteristic line 191 (191A, 191B) demonstrates the characteristic of the diode 10 according to the first arrangement, and a characteristic line 192 (192A, 192B) demonstrates the characteristic example according to the conventional technique.

The conventional technique presented herein is a low injection structure, for example, which includes a low lifetime region formed by adjusting a shallow n buffer layer through laser annealing. Alternatively, the conventional technique is a structure in which a defect layer is formed by irradiation with proton, helium, or the like.

In the low injection structure, the low carrier lifetime region is considered to cause an influence, and a sharp increase in the leakage current in reverse voltage blocking was observed (the characteristic line 192A) when the depletion layer reached the cathode injection layer and the shallow buffer layer thereof. Here, the characteristic line 192B indicates a region where the current steeply increased because the voltage exceeded the withstand voltage of the diode.

In the case where the high injection layer of the cathode is partly replaced with a low injection n type layer in the structure of the conventional technique, the leakage current is considered to increase when the depletion layer invades the low injection portions. Furthermore, with such a pattern structure formed with a depth of about 1 µm, the leakage current also seems to increase due to a spike in the cathode electrode or the like.

Also, when p type regions are partly formed on the cathode side, the leakage current may increase due to hole injection from the p type layer when the depletion layer expands and reaches the vicinity of the p type layer.

In contrast to this, in the structure of the diode 10 according to the first arrangement, before the occurrence of a breakdown (191B), an increase in the leakage current as demonstrated in the characteristic line 191A is much gentler than in the characteristic example of the conventional technique (the characteristic line 192A), and even the increase in the leakage current can be said not to be observed.

The reason for this is that the deep n⁻ buffer layer 111 (FIG. 1) suppresses the expansion of the depletion layer itself, and thus can eliminate an influence of the low injection structure of the cathode, which may cause an increase in the leakage current.

This structure reduces the leakage current, which may cause element breakdown and deterioration, in a state of maintaining dielectric strength and realizes high reliability.

### <<Second Arrangement>>

A diode 10 of a second arrangement is described with reference to the drawings.

FIG. 3 is a diagram showing an example of an upper surface and a cross section of the diode 10 according to the second arrangement.

In FIG. 3, what is different from FIG. 1 is a structure of a low carrier lifetime control layer 161.

The low carrier lifetime control layer 161 is formed partly inside a shallow n buffer layer 112. For example, the low carrier lifetime control layer 161 exists in a cross section taken along a line C2-D2 in FIG. 3 as in the low carrier lifetime control layer 160 in FIG. 1, but does not exist in a cross section taken alone a line C1-D1 in FIG. 3.

FIGs. 4A and 4B are diagrams showing an example of depth-direction cross-sectional profiles on cross sections, taken along the lines C1-D1 and C2-D2 in FIG. 3, of the diode 10 according to the second arrangement. FIG. 4A presents a carrier concentration (distribution) in the depth direction, and FIG. 4B presents a carrier lifetime (distribution) in the depth direction. In FIG. 4B, the carrier lifetimes on both the C1-D1 and C2-D2 cross sections are presented in a superimposed manner for comparison.

To be more specific, FIG. 4B indicates that the carrier lifetime distribution in the shallow n buffer layer 112 varies depending on a positional relationship with the low carrier lifetime control layer 161 as can be seen from the C1-D1 and C2-D2 cross sections.

Here, FIG. 3 showing the second arrangement is different from FIG. 1 showing the first arrangement only in the shape of the low carrier lifetime control layer 161 and accordingly the carrier lifetime distribution. For this reason, the redundant description of the other constituent elements is omitted.

The structure of the low carrier lifetime control layer 161 illustrated in FIG. 3 can be formed by irradiating the shallow n buffer layer 112 with laser annealing as described in FIG. 1 but using a planar pattern different from the planar pattern used in FIG. 1.

As the energy or integrated energy of each irradiation location in the laser annealing irradiation becomes lower, the activation can bring about a lower carrier lifetime.

With this method, it is possible to suppress injection of carriers from the cathode (cathode electrode layer 500) and to desirably vary an amount of carriers injected depending on an area as needed. For example, a reduction in injection to an insulating region around the chip constituting the diode 10, in particular, enables reverse recovery switching in which carrier concentration in a conduction peripheral portion on the anode side is reduced to thereby enhance the ruggedness and suppress the leakage current in a state of maintaining reverse dielectric strength.

The structure illustrated in FIG. 3 can produce the following effects: the total amount of carriers injected from the cathode is reduced to a low level in order to achieve a structure capable of producing the effect of the present invention; and carrier injection in a desired area can be adjusted to a high or very low level as needed.

### <<Third Arrangement>>

A diode 10 of a third arrangement is described with reference to the drawings.

FIG. 5 is a diagram showing an example of an upper surface and a cross section of the diode 10 according to the third arrangement.

In FIG. 5, what is different from FIG. 1 is that a low carrier lifetime control layer 162 is provided in a deep n⁻ buffer layer 111. More specifically, the shallow n buffer layer 112 in FIG. 1 is not present but the deep n-buffer layer 111 also serves as the shallow n buffer layer 112 of the n type.

Here, the high-concentration n⁺ layer 100 in FIG. 1 is presented as a high-concentration n⁺ layer 104 in FIG. 5.

Moreover, FIG. 5 showing the third arrangement is different from FIG. 1 showing the first arrangement only in the absence of the shallow n buffer layer 112, and the positional relationship between the deep n⁻ buffer layer 111 and the low carrier lifetime control layer 161. For this reason, the redundant description of the other constituent elements is omitted.

FIGs. 6A and 6B are diagrams showing an example of depth-direction cross-sectional profiles on a cross section, taken along a line E-F in FIG. 5, of the diode 10 according to the third arrangement. FIG. 6A presents a carrier concentration (distribution) in the depth direction, and FIG. 6B presents a carrier lifetime (distribution) in the depth direction.

In FIGs. 6A and 6B, the carrier concentration and the carrier lifetime are on the E-F cross section in FIG. 5, and correspond to, in order from the anode side, the p type semiconductor layer 120, the n⁻ drift layer 110, the deep n⁻ buffer layer 111 containing the low carrier lifetime control layer 162, and the high-concentration n⁺ layer 104 (a fifth semiconductor layer of the first conductivity type) in FIG. 5.

In the third arrangement, the low carrier lifetime control layer 162 achieves low injection of carriers from the cathode.

Such a low carrier lifetime control layer 162 can be formed by defect generation through irradiation with proton, He, or the like, followed by defect recovery adjustment by an annealing process.

Note that, in FIGs. 6A and 6B, the distribution of the low carrier lifetime control layer 162 is independent of the distribution of the carrier concentration in the deep n⁻ buffer layer 111. Moreover, a portion having a low carrier lifetime has a high resistance value when viewed as a resistor. Thus, the resistance distribution (specific resistance distribution) of the low carrier lifetime control layer 162 is independent of the carrier distribution of the deep n⁻ buffer layer 111.

In other words, the low carrier lifetime control layer 162 has a specific resistance distribution exhibiting a high resistance peak independently of the carrier distribution (impurity concentration distribution) in the deep n⁻ buffer layer 111.

It is preferred to form the low carrier lifetime control layer 162 as close to the high-concentration n⁺ layer 104 as possible in as narrow an area as possible. In this case, in the diode during reverse recovery switching, the depletion layer can be prevented from reaching the low carrier lifetime control layer 162, and thus the generation of a surge voltage and the occurrence of an oscillation phenomenon can be prevented.

Having this structure of the third arrangement, the deep n⁻ buffer layer 111 can produce the effect of coping with more severe conditions such as high bias, small current, and low temperature.

Moreover, since the n⁻ drift layer 110 or the deep n⁻ buffer layer 111 does not affect the carrier lifetime, a loss reduction resulting from a VF reduction can be expected. Further, also in a state of maintaining reverse dielectric strength, the deep n⁻ buffer layer 111 can also produce the effect of preventing the depletion layer from reaching the low carrier lifetime control layer 162, thereby preventing the increase in the leakage current.

### <<Fourth Arrangement>>

A diode 10 of a fourth arrangement is described with reference to the drawing.

FIG. 7 is a diagram showing an example of an upper surface and a cross section of the diode 10 according to the fourth arrangement.

In FIG. 7, what is different from FIG. 5 is that the low carrier lifetime control layer 162 in FIG. 5 is not provided but high-concentration n⁺ regions 101 (a sixth semiconductor layer of the first conductivity type) are formed partly in a deep n⁻ buffer layer 111.

The structure illustrated in FIG. 7 can be formed by: performing implantation in the n+ regions with a photo-pattern or a metal mask; performing pattern irradiation with laser activation as described in the first arrangement; or doing the like.

In FIG. 7, the high-concentration n⁺ regions 101 can each establish an ohmic contact with the cathode electrode layer 500, and receive high carrier injection. Thus, the total amount of carriers injected can be controlled by adjusting an area ratio between the high-concentration n⁺ regions 101 and the other low carrier injection region (the deep n⁻ buffer layer 111), or by appropriately segmenting these regions.

The segmentation of the regions for high and low carrier injections in the structure in FIG. 7 can produce an advantageous structure capable of producing synergistic effects involving not only a reduction in injection of carriers from the cathode, but also an improvement in the ruggedness and a suppression of the leakage current, which are explained in the second arrangement, for example.

### <<Fifth Arrangement>>

A diode 10 of a fifth arrangement is described with reference to the drawing.

FIG. 8 is a diagram showing an example of an upper surface and a cross section of the diode 10 according to the fifth arrangement.

In FIG. 8, what is different from FIG. 7 is that a shallow n buffer layer 113 is provided and a high-concentration n⁺ layer 101 is partly formed in the shallow n buffer layer 113.

The shallow n buffer layer 113 can produce an effect of reducing the leakage current in reverse voltage blocking.

Also, the structure in FIG. 8 is an advantageous structure capable of producing synergistic effects involving not only a reduction in carrier injection from the cathode explained with FIG. 7, but also an improvement in the ruggedness and a suppression of the leakage current, which are explained in the second arrangement, for example.

### <<Sixth Arrangement>>

A diode 10 of a sixth arrangement is described with reference to the drawing.

FIG. 9 is a diagram showing an example of an upper surface and a cross section of the diode 10 according to the sixth arrangement.

In FIG. 9, the sixth arrangement is characterized by including: cathode-side p regions 102 (eighth semiconductor regions of the second conductivity type) each formed in a part of a shallow n buffer layer 113; and high-concentration n⁺ regions 103 (a seventh semiconductor layer of the first conductivity type) each formed in a part of a deep n⁻ buffer layer 111 or the shallow n buffer layer 113 and being in contact with a cathode electrode (a cathode electrode layer 500).

Here, the anode electrode 601, the anode electrode layer 600, the cathode electrode 501, the cathode electrode layer 500, the p type semiconductor layer 120, the n⁻ drift layer 110, and the deep n⁻ buffer layer 111 are the same as those in the structures in FIGs. 1 and 8, and the redundant description thereof is omitted.

In the structure illustrated in FIG. 9, carrier injection occurs to the deep n⁻ buffer layer 111 or the shallow n buffer layer 113 from the cathode-side p regions 102 forwardly-biased during reverse recovery switching, so that a sufficient tail current is produced to obtain a soft waveform.

In addition, also in the structure including the cathode-side p regions (cathode-side p layer) 102 as illustrated in FIG. 9, the lifetime in a region around the high-concentration n⁺ layer (high-concentration n⁺ regions) 103 is set high enough to ensure sufficient carrier injection from the high-concentration n⁺ layer 103, so that the resistance increase and negative resistance properties in the low current regions by the cathode-side p layer 102 can be suppressed.

As described above, it is possible to provide, as a composite effect, the tail current characteristic as in the structure illustrated in FIG. 9 to a cathode structure with sufficiently low carrier injection. In this case, the resultant structure can achieve more stable characteristics.

### <<Seventh Arrangement>>

A diode 10 of a seventh arrangement is described with reference to the drawing.

FIG. 10 is a diagram showing an example of an upper surface and a cross section of the diode 10 according to the seventh arrangement.

In FIG. 10, what is different from FIG. 1 is that a low-concentration p⁻ semiconductor layer 121 and p type semiconductor regions 122 are provided in place of the p type semiconductor layer 120 in FIG. 1.

The low-concentration p⁻ semiconductor layer 121 has a shape with flat surfaces, and the upper surface and the lower surface of the low-concentration p⁻ semiconductor layer 121 are in contact with the anode electrode layer 600 and the n⁻ drift layer 110, respectively.

Meanwhile, the p type semiconductor regions 122 each have a groove-like shape with a curved surface, are located at two or more areas, and are in contact with the anode electrode layer 600, the n⁻ drift layer 110, and the low-concentration p⁻ semiconductor layer 121.

In the diode having the anode structure (the anode electrode layer 600, the low-concentration p⁻ semiconductor layer 121, the p type semiconductor regions 122, and the n⁻ drift layer 110) illustrated in FIG. 10, carrier injection during electric conduction occurs mainly from the p type semiconductor regions 122. This lowers the carrier concentration around the anode, so that during reverse recovery switching, the reverse recovery current can be kept small to thus reduce the loss and obtain a soft switching waveform.

### <<Eighth Arrangement>>

A diode 10 of an eighth arrangement is described with reference to the drawing.

FIG. 11 is a diagram showing an example of an upper surface and a cross section of the diode 10 according to the eighth arrangement.

In FIG. 11, what is different from FIG. 1 is that a low carrier lifetime control layer 163 is provided in the n⁻ drift layer 110.

Here, the other constituent elements are the same as those in the structure in FIG. 1, and the redundant description thereof is omitted.

In the diode 10 in the eighth arrangement illustrated in FIG. 11, the low carrier lifetime control layer 163 reduces the carrier injection from the p type semiconductor layer 120 to the n⁻ drift layer 110, and thus can also produce the same effect as the anode side in the diode 10 in the seventh arrangement illustrated in FIG. 10.

### <<Ninth Arrangement>>

A power convertor 20 according to a ninth arrangement is described with reference to the drawing.

FIG. 12 is a diagram showing a configuration example of the power convertor 20 according to the ninth arrangement.

In FIG. 12, a U phase leg is formed by connecting an IGBT 701 and an IGBT 702 in series. Similarly, a V phase leg is formed by an IGBT 703 and an IGBT 704, and a W phase leg is formed by an IGBT 705 and an IGBT 706.

In addition, gate circuits 801 to 806 control the IGBTs 701 to 706, respectively.

Moreover, diodes 711 to 716 are connected in anti-parallel to the IGBTs 701 to 706, respectively.

A power supply voltage Vcc that is a direct current voltage from a power supply 900 is applied via a negative N terminal 901 and a positive P terminal 902 to the IGBTs 701 and 702 of the U phase, the IGBTs 703 and 704 of the V phase, and the IGBTs 705 and 706 of the W phase, so that the direct current voltage (electric power) is supplied to the IGBTs 701 to 706.

Then, the gate circuits 801 to 806 integrally control the IGBTs 701 to 706, and thereby a three phase current voltage (electric power) with variable voltage and variable frequency can be generated from output terminals (a U terminal, a V terminal, and a W terminal) 910 to 912 of the U phase leg, the V phase leg, and the W phase leg.

In short, the power convertor 20 constitutes an inverter that converts a direct current voltage (electric power) into a three phase current voltage (electric power) with variable voltage and variable frequency.

This three phase current voltage (electric power) is supplied from the output terminals 910 to 912 to a motor (three phase current motor) 950, so that the motor 950 can be driven with the variable voltage and the variable frequency.

The feature of the power convertor 20 illustrated in FIG. 12 is that the diodes 711 to 716 are formed by using diodes in any of the structures of the first to eighth arrangements.

Using diodes in any of the structures of the first to eighth arrangements, the power convertor (inverter) 20 in FIG. 12 achieves a loss reduction, a noise reduction, and reliability enhancement of the inverter.

### <<Other Arrangements>>

It should be noted that the present invention is not limited to the foregoing arrangements, but may include various modifications. For example, the above arrangements are described in details for explaining the present invention in an easily understandable manner, and the present invention is not necessarily limited to one including all the constituent elements mentioned above. Moreover, part of the structure of one of the arrangements may be replaced with part of the structure of another one of the arrangements, and the structure of one of the arrangements may additionally include part or all of the structure of another one of the arrangements.

Hereinafter, further description is provided for other arrangements and modifications.

### <<Specification of Thickness of Deep n Type Buffer Layer>>

The first arrangement is described such that the deep n⁻ buffer layer 111 has a thickness of 30 µm or more, and a carrier concentration of less than 1×10¹⁵ cm⁻³, but the thickness and the carrier concentration are not limited to these.

More specifically, the thickness of the deep n-buffer layer 111 may be specified as a thickness that allows the deep n type buffer layer to have a carrier concentration (volume concentration) of less than 1×10¹⁵ cm⁻³ and have a total carrier concentration (area concentration) of 1×10¹¹ to less than 1×10¹³ cm⁻².

### <<Formation of Deep n Type Buffer Layer>>

In the first arrangement, as a method of forming the deep n⁻ buffer layer 111, described is the method of mainly diffusing P, As, Sb, or the like in the case of a silicon semiconductor layer.

However, the formation method is not limited to the above method. More effective formation means is a formation method of generating oxygen thermal donor by causing the deep n⁻ buffer layer 111 to contain oxygen.

In terms of this method, the diffusion coefficient of oxygen is two orders of magnitude larger than that of P, which is a group V element. Thus, oxygen can be diffused deeply in a short period of time.

In addition, oxygen is also used in a normal diffusion atmosphere, and the deep n⁻ buffer layer 111 in the first arrangement illustrated in FIG. 1 can be formed in an oxygen atmosphere by heat treatment without using a special device.

The oxygen thermal donor is annihilated by heat treatment at 800°C or higher, and is generated by heat treatment at 400 to 600°C.

Using the above properties, the n type carrier concentration in the n type buffer layer (the deep n-buffer layer 111: FIG. 1) can be accurately adjusted, for example, through usual diode formation steps of: performing heat treatment at 800°C to 1000°C as activation annealing for the n type layer or as densification annealing for a boron phosphorus silicon glass (BPSG) film formed as an interlayer insulating film, thereby annihilating the oxygen thermal donor; and thereafter performing annealing at 400°C to 500°C as sintering after electrode formation using Al or the like, thereby generating the oxygen thermal donor.

In addition, the study of the present inventors revealed that the n type carrier concentration in the oxygen thermal donor is proportional to approximately the fifth power of the oxygen concentration. Thus, by setting the oxygen concentration to 1×10¹⁷ cm⁻³ or more, the n type carrier concentration in the thermal donor can be made higher than that in the n⁻ layer (the deep n⁻ buffer layer 111: FIG. 1).

### <<Low Injection Structure of Carriers from Cathode>>

In the first arrangement, the formation of the low carrier lifetime control layer 160 is explained including: forming the shallow n buffer layer 112 by implanting n type impurities into a region of 1.5 to 10 µm from the cathode electrode layer; and forming a low carrier lifetime control layer by not activating all the impurities in the above region but leaving a defect layer in the region in the process of laser annealing of the shallow n buffer layer 112.

However, the method of forming the low carrier lifetime control layer 160 is not limited to the above method.

For example, the same effect can be also obtained by irradiation with an inert element such as proton or helium, followed by annealing while leaving a defect layer.

Instead, the low injection structure can be also attained by forming an area in contact with the cathode electrode (cathode electrode layer 500) to have a structure in which high injection n type regions are formed in parts of the area, and a low injection n type layer is formed in the other parts of the area instead of the high injection n type region.

Alternatively, the formation of the low carrier lifetime control layer 160 can be also accomplished by forming an area in contact with the cathode electrode (cathode electrode layer 500) to have a structure in which high injection n type regions are formed in parts of the area and p type semiconductor regions are formed in the other parts of the area.

### <<Combination of Structures>>

The seventh arrangement employs the structure including the low-concentration p⁻ semiconductor layer 121 and the p type semiconductor regions 122 as illustrated in FIG. 10. This is intended to improve the structure on the anode side.

In contrast, the first to sixth arrangements are intended to improve the structure on the cathode side as illustrated in FIGs. 1, 3, 5, and 7 to 9.

Thus, it is also possible to combine the anode-side structure including the low-concentration p⁻ semiconductor layer 121 and the p type semiconductor regions 122 illustrated in FIG. 10 with the cathode-side structure in any of the first to sixth arrangements.

In this case, the two combined structures may possibly produce the combined effects of the two structures.

Moreover, the eighth arrangement employs the structure including the low carrier lifetime control layer 163 in the n⁻ drift layer 110 as illustrated in FIG. 11.

This structure may be also combined with any of the structures in the second to sixth arrangements illustrated in FIGs. 3, 5, and 7 to 9.

In this case, the two combined structures may possibly produce the combined effects of the two structures.

### <<Power Convertor>>

FIG. 12 showing the ninth arrangement presents an inverter, which is equipped with the diodes in any of the first to eighth arrangements described above, and which converts the direct current voltage (electric power) to the three phase current voltage (electric power). However, FIG. 12 is just an example, and the power convertor is not limited to this.

For example, the power convertor may be an inverter with a single phase structure or a four or more phase structure instead of a three phase structure.

Moreover, what is equipped with diodes in any one of the first to eighth arrangements is not limited to the inverter.

For example, the power convertor may be a convertor which converts an alternating current to a direct current, for example. Moreover, in any other power convertors such as step-up and step-down choppers using a diode, the same effects can be obtained.

Note that the signs in FIGs. 13 and 14 are the signs in [Abstract] in Patent Literatures 1 and 2, and are inconsistent with the signs in the drawings of the present application described above.

## Claims

1. A diode (10) comprising:
an anode electrode layer (600);
a cathode electrode layer (500);
a buffer layer (111) of a first conductivity type formed between the anode electrode layer (600) and the cathode electrode layer (500) in a region extending to a location at a distance of 30 µm or more from the cathode electrode layer (500);
a first semiconductor layer (110) of the first conductivity type formed in a region between the anode electrode layer (600) and the buffer layer (111), and being in contact with the buffer layer (111); and
a second semiconductor layer (120) of a second conductivity type formed in a region between the anode electrode layer (600) and the first semiconductor layer (110) of the first conductivity type, wherein
a carrier concentration in the first semiconductor layer (110) is lower than a carrier concentration in the buffer layer (111),
the carrier concentration in the buffer layer (111) is less than 1×10¹⁵ cm⁻³,
wherein the diode (10) further comprises a third semiconductor layer (112) of the first conductivity type adjacent to the buffer layer (111),
the third semiconductor layer (112) has a carrier concentration of 1×10¹⁵ cm⁻³ or more,
wherein the cathode electrode layer (500),
the third semiconductor layer (112),
the buffer layer (111),
the first semiconductor layer (110),
the second semiconductor layer (120) and
the anode electrode layer (600) are arranged over each other in this order along a first direction, the diode being **characterised in that** a low carrier lifetime control layer (161) at which a carrier lifetime becomes low is buried within the third semiconductor layer (112), and
the low carrier lifetime control layer (161) has a specific resistance distribution exhibiting a high resistance peak independently of an impurity concentration distribution in the third semiconductor layer (112), the low carrier lifetime control layer (161) consisting of a plurality of portions located in a plane perpendicular to said first direction and spaced apart from each other.

2. The diode (10) according to claim 1, wherein
the buffer layer (111) has a total carrier concentration of 1×10¹¹ to 1×10¹³ cm⁻².

3. The diode (10) according to claim 1, further comprising a fourth semiconductor layer (100) of the first conductivity type being in contact with the third semiconductor layer (112), wherein
the fourth semiconductor layer (100) is in contact with a whole surface of the cathode electrode layer (500), and has a carrier concentration of 1×10¹⁹ cm⁻³ or more that is higher than that of the third semiconductor layer (112).

4. A power convertor comprising a diode (10) according to any one of claims 1 to 3.

## Patentansprüche

1. Diode (10), die Folgendes umfasst:
eine Anodenelektroden-Schicht (600);
eine Kathodenelektroden-Schicht (500);
eine Pufferschicht (111) eines ersten Leitfähigkeitstyps, die zwischen der Anodenelektroden-Schicht (600) und der Kathodenelektroden-Schicht (500) in einem Bereich gebildet ist, der sich bis zu einem Ort erstreckt, der sich in einer Entfernung von 30 µm oder mehr zu der Kathodenelektroden-Schicht (500) befindet;
eine erste Halbleiterschicht (110) des ersten Leitfähigkeitstyps, die in einem Bereich zwischen der Anodenelektroden-Schicht (600) und der Pufferschicht (111) gebildet ist und sich im Kontakt mit der Pufferschicht (111) befindet; und
eine zweite Halbleiterschicht (120) eines zweiten Leitfähigkeitstyps, die in einem Bereich zwischen der Anodenelektroden-Schicht (600) und der ersten Halbleiterschicht (110) des ersten Leitfähigkeitstyps gebildet ist, wobei
eine Ladungsträgerkonzentration in der ersten Halbleiterschicht (110) niedriger ist als eine Ladungsträgerkonzentration in der Pufferschicht (111),
die Ladungsträgerkonzentration in der Pufferschicht (111) kleiner als 1 × 10¹⁵ cm⁻³ ist,
wobei die Diode ferner eine dritte Halbleiterschicht (112) des ersten Leitfähigkeitstyps neben der Pufferschicht (111) umfasst,
die dritte Halbleiterschicht (112) eine Ladungsträgerkonzentration von 1 × 10¹⁵ cm⁻³ oder mehr aufweist,
wobei die Kathodenelektroden-Schicht (500),
die dritte Halbleiterschicht (112),
die Pufferschicht (111),
die erste Halbleiterschicht (110),
die zweite Halbleiterschicht (120) und
die Anodenelektroden-Schicht (600) in dieser Reihenfolge in einer ersten Richtung übereinander angeordnet sind,
wobei die Diode **dadurch gekennzeichnet ist, dass**
eine Steuerschicht (161) mit niedriger Ladungsträgerlebensdauer, an der eine Ladungsträgerlebensdauer niedrig wird, in der dritten Halbleiterschicht (112) vergraben ist, und
die Steuerschicht (161) mit niedriger Ladungsträgerlebensdauer eine spezifische Widerstandsverteilung aufweist, die unabhängig von einer Störstellenkonzentrationsverteilung in der dritten Halbleiterschicht (112) eine hohe Widerstandspitze zeigt,
wobei die Steuerschicht (161) mit niedriger Ladungsträgerlebensdauer aus mehreren Abschnitten besteht, die in einer Ebene, die senkrecht zu der ersten Richtung ist, liegen und voneinander beabstandet sind.

2. Diode (10) nach Anspruch 1, wobei
die Pufferschicht (111) eine Gesamtladungsträgerkonzentration von 1 × 10¹¹ bis 1 × 10¹³ cm⁻² aufweist.

3. Diode (10) nach Anspruch 1, die ferner eine vierte Halbleiterschicht (100) des ersten Leitfähigkeitstyps umfasst, die sich in Kontakt mit der dritten Halbleiterschicht (112) befindet, wobei
sich die vierte Halbleiterschicht (100) in Kontakt mit einer gesamten Oberfläche der Kathodenelektroden-Schicht (500) befindet und eine Ladungsträgerkonzentration von 1 × 10¹⁹ cm⁻³ oder mehr enthält, die höher ist als die der dritten Halbleiterschicht (112).

4. Leistungsumsetzer, der eine Diode (10) nach einem der Ansprüche 1 bis 3 umfasst.

## Revendications

1. Diode (10) comprenant :
une couche d'électrode d'anode (600) ;
une couche d'électrode de cathode (500) ;
une couche tampon (111) d'un premier type de conductivité formée entre la couche d'électrode d'anode (600) et la couche d'électrode de cathode (500) dans une région s'étendant jusqu'à un emplacement situé à une distance de 30 µm ou plus à partir de la couche d'électrode de cathode (500) ;
une première couche semi-conductrice (110) du premier type de conductivité formée dans une région entre la couche d'électrode d'anode (600) et la couche tampon (111), et qui est en contact avec la couche tampon (111) ; et
une deuxième couche semi-conductrice (120) d'un deuxième type de conductivité formée dans une région entre la couche d'électrode d'anode (600) et la première couche semi-conductrice (110) du premier type de conductivité, dans laquelle
une concentration de porteurs dans la première couche semi-conductrice (110) est inférieure à une concentration de porteurs dans la couche tampon (111),
la concentration de porteurs dans la couche tampon (111) est inférieure à 1×10¹⁵ cm⁻³,
dans laquelle la diode (10) comprend en outre une troisième couche semi-conductrice (112) du premier type de conductivité adjacente à la couche tampon (111),
la troisième couche semi-conductrice (112) a une concentration de porteurs de 1×10¹⁵ cm⁻³ ou plus,
dans laquelle
la couche d'électrode de cathode (500),
la troisième couche semi-conductrice (112),
la couche tampon (111),
la première couche semi-conductrice (110),
la deuxième couche semi-conductrice (120) et
la couche d'électrode d'anode (600) sont disposées les unes sur les autres dans cet ordre le long d'une première direction,
la diode étant **caractérisée en ce**
**qu'**une couche de commande à faible durée de vie des porteurs (161) au niveau de laquelle une durée de vie des porteurs devient faible est enfouie dans la troisième couche semi-conductrice (112) et
**que** la couche de commande à faible durée de vie des porteurs (161) a une distribution de résistance spécifique présentant un pic de résistance élevé indépendamment d'une distribution de concentration d'impuretés dans la troisième couche semi-conductrice (112),
la couche de commande à faible durée de vie des porteurs (161) consistant en une pluralité de parties situées dans un plan perpendiculaire à ladite première direction et espacées les unes des autres.

2. Diode (10) selon la revendication 1, dans laquelle
la couche tampon (111) présente une concentration totale de porteurs de 1×10¹¹ à 1x10¹³ cm⁻².

3. Diode (10) selon la revendication 1, comprenant en outre une quatrième couche semi-conductrice (100) du premier type de conductivité qui est en contact avec la troisième couche semi-conductrice (112), dans laquelle
la quatrième couche semi-conductrice (100) est en contact avec une surface entière de la couche d'électrode de cathode (500) et présente une concentration de porteurs de 1x10¹⁹ cm⁻³ ou plus qui est plus élevée que celle de la troisième couche semi-conductrice (112).

4. Convertisseur de puissance comprenant une diode (10) selon l'une quelconque des revendications 1 à 3.
